# FASCICULE DE BREVET EUROPEEN

(11) **EP 1 520 914 B1**
(45) Date de publication et mention de la délivrance du brevet: **31.05.2006**
(21) Numéro de dépôt: 03293346.7
(22) Date de dépôt: 29.12.2003
(51) Int. Cl.: C23C 14/30, C23C 14/50

(54) **Installation de revêtement de pièces par faisceaux d'électrons**
Anlage zum Beschichten von Werkstücken durch Elektronenstrahlen
Installation for coating work pieces using electron beam

(30) Priorité: 23.09.2003 CH 16232003
(43) Date de publication de la demande: 06.04.2005
(73) Titulaire: GBA S.A., 1820 Montreux (CH)
(72) Inventeur: Hrechaniuk, Mikola, Kyiv 02154 (UA); Koucherenko, Pavlo, Kyiv 03049 (UA)
(74) Mandataire: Faber, Jean-Paul

(56) Documents cités:
- FR-A- 2 827 307
- JP-A- 52 047 530
- US-A- 4 108 107
- US-A- 4 192 253

## Description

La présente invention est relative à la métallurgie sous vide, et elle peut être utilisée pour le revêtement de produits de profil sophistiqué.

Actuellement, on recherche de plus en plus des revêtements ayant des caractéristiques spécifiques physiques et mécaniques.

On sait que l'évaporation à faisceaux d'électrons et la condensation postérieure sous vide de matériaux métalliques et non métalliques est un procédé précis pour la réalisation de matériaux tant au niveau atomique que moléculaire. En faisant varier la température du dépôt de concentration des phases, la vitesse de rotation des produits à revêtir, il est facile d'obtenir un revêtement à gradient de concentration de phases, des revêtements microporeux ou multicouches.

Naturellement, pour réaliser ces revêtements sur des pièces de configuration sophistiquée, par exemple des aubes de turbines à gaz, il est nécessaire de disposer de matériels appropriés à faisceaux d'électrons. On connaît quelques installations de vide destinées à la réalisation des revêtements composites.

Le dépôt de revêtement formé de trois couches est réalisé dans l'installation de vide multichambres par voie de déplacement du support d'une chambre à l'autre ; dans chacune d'elles une couche est déposée.

Dans la chambre de travail de l'installation de vide, sous le support protégé, on met l'un après l'autre les creusets contenant les matériaux à évaporer.

Dans la chambre de travail de l'installation de vide, les évaporateurs fonctionnent alternativement, et le support et la plaque de masques peuvent librement pivoter et être déplacés.

Les installations de vide décrites ci-dessus présentent les inconvénients suivants :
a) le dépôt des couches : l'une après l'autre, une seule couche à la fois, engendre une basse productivité des installations de vide ;
a) au moment du remplacement des creusets, la vitesse de l'évaporation des composants est variée, du fait de l'hétérogénéité de structure en épaisseur des composants ce qui entraîne la détérioration des caractéristiques physiques et chimiques de l'ensemble ;
a) l'inconvénient principal des solutions techniques connues réside dans l'impossibilité de déposer le revêtement de tous côtés. Dans les installations de vides décrites ci-dessus la formation du revêtement de protection est exécutée seulement sur le côté de la pièce tourné vers l'évaporateur.

On connaît aussi des matériels de vide pour le dépôt d'un revêtement multicomposants sur toutes les surfaces des pièces ayant un profil sophistiqué (les aubes de turbines à gaz). Toutefois, ces installations ne permettent pas de réaliser des revêtements à gradient et multicouches.

Il sera donné ci-après un aperçu détaillé des équipements à faisceaux d'électrons utilisés pour le dépôt des revêtements de protection. L'analyse de ces équipements montre que l'installation industrielle la plus universelle pour le dépôt des revêtements composites protecteurs sur des produits de formes sophistiquées est l'installation Y3-175 de l'institut de soudage électrique de Y.O. Paton de l'Académie Nationale des Sciences de l'Ukraine, dont la description détaillée est donnée ci-après. Cette installation est destinée notamment pour la formation du revêtement de protection contre la corrosion sur la surface des aubes de turbomoteurs par procédé d'évaporation à faisceaux d'électrons. Le processus du revêtement implique le nettoyage ionoplasmique à chaud des aubes montées sur un châssis, dans une chambre (de préparation), suivi du dépôt du matériau évaporé à partir des creusets sur la surfaces des aubes. Le chauffage et l'évaporation du matériau s'effectue sous l'action des faisceaux d'électrons. L'installation est composée d'un groupe de chambres à vide avec des mécanismes, dispositifs et systèmes assurant le déroulement du processus technologique semi-continu. Dans la chambre de dépôt des revêtements, il est situé deux creusets cylindriques du matériau à évaporer qui est formé de composants métalliques et trois creusets rectangulaires de type "nacelle" pour évaporer des composants métalliques ou des composants céramiques. L'évaporation du matériau de chacun des creusets se passe séparément sous l'action des faisceaux d'électrons provenant des canons à électrons commandés individuellement.

Puisque les pièces à revêtir (les aubes) pendant le déplacement de la chambre de préparation à la chambre de dépôt de revêtements se sont refroidies, au-dessus de la chambre de dépôt est installé un canon supplémentaire pour réchauffer les aubes avant de déposer le revêtement. Lors du réchauffage, les pièces à revêtir sont isolées des creusets par des volets. Lorsque les pièces à revêtir ont atteint la température nécessaire (contrôlée à l'aide de pyromètres et thermocouples), les volets sont ouverts et le processus de dépôt du revêtement commence.

Les brevets Etats-Unis n° 4 122 221 du 24 Octobre 1978 et Allemagne n° 2 813 180 du 4 Octobre 1979 décrivent une installation permettant de former non seulement des revêtements multicomposants de type MeCrAlY, où Me-Co, Ni, Fe, mais aussi des revêtements composites de type MeCrAlY-Me-O, ou Me-C.

L'exploitation pilote desdites installations dans des entreprises de la Russie (le Groupement scientifique et productif "Troude", ville de Samara, Usine de constructions mécaniques de Lytkarynsk, région de Moscou), de l'Ukraine (SPB "Machprojet", ville de Mykolaïv, l'Usine de turbines du sud "Zoria", ville de Mykolaïv) a permis de découvrir des inconvénients constructifs. Le chauffage préalable des aubes dans les chambres a été reconnu comme inopportun. Dans les chambres, à la suite des chargements-déchargements continus, le condensat de l'air est accumulé et après le réchauffage des pièces engendre la formation de pellicules d'oxyde sur leurs surfaces. Lors du dépôt d'un revêtement protecteur, la présence de la couche d'oxyde provoque inévitablement une dissociation du revêtement au cours de l'exploitation des pièces.

Lors de l'évaporation des composés oxydés, carburés ou borurés du creuset de type "nacelle" des cratères se forment sur la surface et entraînent inévitablement la variation de la vitesse de l'évaporation de ces composés de sorte que les revêtements composites de type MeCrAlY-Me-O, Me-C, Me-B ont une composition chimique hétérogène et sont impropres à l'exploitation.

Pour ces raisons, la construction de l'installation Y3-175 a été modifiée et ses versions postérieures (installations Y3-187, Y3-177 M) sont munies d'un bloc de creusets composé de quatre creusets cylindriques alignés en une rangée. Ce type de bloc de creusets permet d'assurer l'alimentation continue des matériaux consommés dans la zone d'évaporation. Dans les creusets, on peut charger les produits coulés ou des barreaux céramiques ayant jusqu'à 800 mm de longueur. Tous les canons sont équipés de programmateurs de balayage des faisceaux d'électrons. Ainsi, par voie d'une sélection du programme de balayage approprié, il est possible d'assurer la vaporisation régulière des composants qui sont sublimés au réchauffage par faisceaux d'électrons sans former des cratères. Les installations de ce type sont munies d'un système de commande automatisé. Ainsi avec l'élaboration d'un programme approprié, il est facile de former des revêtements composites de type durci par dispersion ou microcouche respectivement MeCrAlY-MeO, MeC, MeB ou MeCrAlY/ MeCrAlY+MeO, MeC, MeB pour obtenir un revêtement à gradient de phases dans l'épaisseur. Des installations industrielles de type Y3-187 M sont exploitées à l'Institut de soudage électrique de Y.O. Paton de l'Académie Nationale des Sciences de l'Ukraine pour le dépôt des revêtements de deux où plusieurs couches ainsi que par les firmes des Etats-Unis d'Amérique et d'Allemagne, en particulier par la firme américaine "Pratt and Whitney".

Malgré les possibilités étendues desdites installations, actuellement la firme américaine "Pratt and Whitney" utilise un procédé combiné de dépôt des revêtements de protection thermique. La couche intérieure métallique Ni(Co)CrAlYHfSi est déposée par pulvérisation au plasma et la couche extérieure céramique par sédimentation à faisceaux d'électrons.

Une telle solution technique rend impossible l'addition d'une quantité nécessaire de l'yttrium, de l'hafnium, de silicium, de zirconium en couche intérieure métallique par voie de l'évaporation d'une seule source.

Le bloc des creusets avec la disposition linéaire de quatre creusets cylindriques peut être utilisé pour obtenir des revêtements métalliques MeCrAlY dopés en addition du zirconium, de l'hafnium ou du silicium. On peut obtenir par voie d'évaporation indépendante des sources autonomes (creusets) des alliages de type MeCrAlY et des métaux résistant à de hautes températures. Cependant, à cause de la disposition linéaire des creusets, il est difficile d'assurer une répartition régulière des composants dans le revêtement sur toute la longueur de l'ailette d'une aube, par exemple pour un alliage MeCrAlY on prévoit une évaporation du creuset central, l'additif dopant (hafnium) du creuset droit et du creuset gauche, voisins du creuset central. Lorsque l'addition simultanée à la composition de revêtement d'un additif supplémentaire, par exemple, du silicium est nécessaire, il est impossible d'utiliser un tel schéma parce que par évaporation de trois matériaux différents de trois creusets autonomes, on ne peut obtenir l'homogénéité chimique de la composition chimique du revêtement.

Avec l'installation ci-dessus, il est impossible de déposer des revêtements thermoprotecteurs à deux couches de type MeCrAlYHfSi/MeO pendant un cycle technologique parce que préalablement il faut charger les composants de la couche métallique dans au moins trois creusets et seulement après cela utiliser ces creusets pour le dépôt de la couche céramique. Pour cette raison, dans les installations Y∋-175, Y∋-187 fabriquées en série, on a proposé une nouvelle construction d'un bloc de creusets permettant d'éliminer lesdits inconvénients. Ce bloc des creusets est équipé de creusets de type "nacelle", fabriqués en forme de demi-bagues et approchées en maximum du creuset central. Ladite construction du bloc de creusets permet d'évaporer l'alliage MeCrAlY du creuset central, des additifs dopants Y, Hf, Si, Zr des creusets de type "nacelle", et le composant céramique de trois autres creusets cylindriques. Les composants dopants Y, Hf, Si, Zr sont placés dans les creusets sous forme de comprimés (pesés, produits coulés) et situés selon un schéma géométrique précis au périmètre des creusets. La masse des comprimés (produits coulés) de Y, Hf, Si, Zr et le schéma géométrique de leur placement dans les creusets sont établis à partir du calcul de la concentration nécessaire desdits éléments dans la couche MeCrAlYHfSiZr, ainsi que les dimensions des produits à revêtir.

Le canon à faisceaux d'électrons utilisé à l'évaporation des composants dopants Y, Hf, Si, Zr est muni du bloc électronique spécial permettant, par mise en oeuvre d'un programme donné, de varier la densité du faisceau électronique au périmètre de la surface des creusets dans lesquels des comprimés (produits coulés) de composants dopants Y, Hf, Si, Zr sont chargés. Ainsi, par voie de la variation de la densité du faisceau électronique, les dimensions géométriques des barreaux (produits coulés) de composants dopants et leur placement dans les creusets, on a réussi à obtenir la concentration nécessaire des additifs dopants dans le revêtement sur toute la surface des pièces à revêtir.

Grâce au dopage des compositions maîtres MeCrAlY, Y, Hf, Si, Zr, à la présence des inclusions dispersées d'oxydes dans les microcouches composites, le processus de diffusion par les interfaces des couches pourra être complexe. De plus, des zones sur la base de spinelles complexes de type 2Y₂O₃*Al₂O3, 3Al₂O3*2SiO₂ seront formées de 2 à 2,5 fois plus lentement qu'aux mêmes conditions des essais dans le revêtement de deux couches MeCrAlY/MeO.

Les installations industrielles à faisceaux d'électrons de type Y∋-175, Y∋-187 munies de tels blocs de creusets permettent de faire des revêtements protecteurs pratiquement de toutes gammes, à partir de ceux les plus simples de type MeCrAlY jusqu'à ceux de ceux de deux couches de type MeCralYHfSiZr/Me et à ceux de trois couches MeCrAlYHfSiZr/ MeCrAlYHfSiZr+MeO/ZrO₂-Y₂O₃, où MeO- est l'oxyde d'aluminium ou dioxyde de zirconium stabilisé par l'oxyde d'yttrium. A cela la couche composite MeCrAlYHfSiZr+MeO- peut être exécutée comme la couche de MeCrAlYHfSiZr métallique et la couche de MeCrAlYHfSiZr+MeO composite, alternées de 0,5 à 1,2 µm d'épaisseur de la microcouche. Il existe aussi la possibilité de faire les revêtements à gradient de la concentration des composants et des composés, etc.

Une nouvelle génération d'installations de turbines à gaz permet l'élaboration d'aubes non refroidies revêtues à base de métaux et d'alliages hautes températures. Actuellement, l'obtention des alliages à base de métaux hautes températures ayant des propriétés mécaniques de haut niveau pose un problème. Le problème principal de leur utilisation étendue dans la construction de turbine à gaz est la protection efficace des alliages contre l'oxydation au cours de l'exploitation sur un long laps de temps (centaines ou milliers d'heures). Les revêtements siliciurés durcis par dispersion, particulièrement ceux modifiés par les éléments dopants comme le bore, l'aluminium, le titane, le chrome, etc. constituent l'un des types principaux de revêtements qui protègent les métaux hautes températures et leurs alliages contre l'oxydation à haute température. Aux Etats-Unis, la réalisation de revêtements protecteurs contre la haute température est appliquée par environ 100 firmes industrielles et centres scientifiques, dont une grande partie travaille dans le domaine de la création des revêtements réfractaires pour les métaux hautes températures. On a constaté que pour la gamme des hautes températures (jusqu'à 1573 à 2003 K), c'est l'utilisation des intermétalloïdes, notamment de siliciures, qui offre les meilleures perspectives. Mais les études réalisées pendant les trois dernières décennies, n'ont eu comme résultat que la création des revêtements efficaces de siliciures pour protéger des produits fabriqués en des métaux et alliages hautes températures qui peuvent être utilisés durant un long laps de temps et dans des conditions extrêmes d'exploitation.

On a décrit en détail les principaux procédés de formation des revêtements siliciurés et des équipements industriels nécessaires pour cette exploitation. On peut distinguer les procédés principaux suivants de la formation de revêtements siliciurés :
1) Saturation obtenue des mélanges gaz-vapeur contenant les composés du silicium, surtout ceux d'haloïde, avec ou sans l'hydrogène (la siliciuration dans la phase gazeuse) ;
2) Saturation obtenue dans les vapeurs du silicium (siliciuration sous vide) ;
3) Saturation obtenue da la phase liquide par électrolyse ou sans elle (siliciuration dans la phase liquide) ;
4) Saturation obtenue dans les mélanges en poudre contenant le silicium, en présence des activateurs (siliciuration solide dans la phase liquide).

Il est à noter que les revêtements siliciurés sous vide ont les meilleures caractéristiques techniques. La siliciuration sous vide est exécutée notamment dans la charge de la poudre du silicium de haute pureté ; en outre, on peut l'exécuter à condition que les métaux à saturer et le silicium soient éloignés l'un de l'autre et puissent être chauffés à des températures différentes. Mais le processus de la siliciuration sous vide est long, cher et représente une faible productivité, d'autant plus que les pièces ont des formes complexes et un grand encombrement.

La principale propriétés des revêtements siliciurés est la résistance à la chaleur. Les disiliciures des métaux des sous-groupes IV et VI sont caractérisés par la résistance à chaleur la plus haute. Leur comportement à l'air ou à l'oxygène (à diverses pressions), dans une gamme étendue des températures, est connu. On peut ranger les disiliciures des sous-groupes IV et VI selon l'accroissement de la résistance à l'oxydation à l'air dans la formule suivante : TiSi₂, ZrSi₂, NbSi₂ sont résistants aux températures de 1073 à 1373 K ; TaSi₂ - de 1373 à 1673 K ; CrSi₂, Wsi₂ - de 1673 à 1973 K, MoSi₂ - de 1973 à 2073 K.

La création des revêtements sur la base des composés complexes de siliciures dopés en supplément du bore, du titane et d'autres éléments suscite un grand intérêt.

On peut obtenir un accroissement supplémentaire de la fiabilité des produits avec des revêtements siliciurés par la voie de la formation des revêtements combinés de deux couches de type siliciure/oxyde (MeSi₂/MeO).

Cependant les procédés traditionnels du dépôt des revêtements siliciurés ne permettent pas de former des revêtements semblables de deux couches ou de plusieurs couches.

L'évaporation à faisceaux d'électrons suivie de la condensation sous vide des matériaux métalliques et non métalliques ouvre certaines possibilités pour la formation de tels revêtements.

Néanmoins, les constructions des installations à faisceaux d'électrons décrites ci-dessus ne permettent pas de réaliser industriellement le dépôt de revêtements siliciurés sur les pièces pour les raisons suivantes : on sait que Si, Ti, Zr, Nb, W, Cr- sont essentiellement distingués en tension des vapeurs. C'est pourquoi, l'évaporation des composés de type MeSi₂ à partir d'un creuset n'est pas possible. Dans les installations industrielles à faisceaux d'électrons avec l'évaporation de plusieurs creusets et une disposition linéaire des creusets, il est possible de synthétiser les composés dans la phase de vapeur. Cependant, dans ce cas, on a constaté l'apparition d'une hétérogénéité importante du composé chimique du revêtement siliciuré correspondant à la longueur d'une pièce qui est recouverte par exemple à l'évaporation Ti et Si de deux creusets situés en ligne. Le dépôt de revêtements siliciurés plus complexe de quatre creusets disposés en ligne n'est pas réalisable.

Les revêtements siliciurés peuvent être synthétisés dans les installations à faisceaux d'électrons avec plusieurs creusets disposés circulairement. Une telle réalisation est décrite ci-après.

Les produits de départ en forme de produits coulés ou de barreaux frittés ont été montés dans quatre creusets en cuivre refroidis par eau de 70 mm de diamètre situés circulairement. Les produits coulés ou les barreaux ont été montés sur les tiges en cuivre refroidies par eau et liées avec des mécanismes d'amenée verticale. Le dépôt des flux de vapeurs divisés ou mêlés a été fait sur un support tournant fabriqué en acier inox de 8 mm en forme de disque de 520 mm de diamètre. La vitesse de rotation du support a été réglée dans la gamme de 0,05 à 200 t/min.

La vitesse de rotation est strictement constante et ce à l'aide du bloc monophasé à thyristors 3TO 1. Six réchauffeurs à faisceaux d'électrons de puissance de 60 kW chacun sont destinés à faire évaporer les produits de départ et à réchauffer le support.

L'installation est munie des unités de contrôle des réchauffeurs à faisceaux d'électrons. Le système d'automatisation utilisé permet de soutenir et de régler la vitesse nécessaire de l'évaporation de chacun des composants au cours de tout le processus technologique, ainsi que de faire évaporer des matériaux au mode pulsatoire.

A ladite installation, grâce à la modification de la géométrie de la disposition des quatre creusets, il est facile de synthétiser les revêtements siliciurés par une couche ou deux couches, par exemple, en faisant évaporer du Ti et du Si de deux creusets situés l'un à côté de l'autre, du Zr et du Si de deux autres creusets. En utilisant ledit schéma technologique, il est aussi facile de former les revêtements de deux couches de type MeSi₂/MₑO. Cependant, ladite installation permet de faire le dépôt des revêtements seulement sur un côté des pièces à revêtir. La productivité est très basse, parce qu'après le dépôt d'un revêtement, il faut prévoir un temps de refroidissement des pièces et charger un nouveau lot de pièces à revêtir dans la chambre principale. L'ouverture fréquente de la chambre principale engendre la formation du condensat de l'humidité de l'air sur les parois de la chambre. Lors du réchauffement des produits, l'humidité des parois de la chambre est condensée sur leur surface en formant les oxydes superficiels causant l'écaillage du revêtement déposé.

L'installation la plus proche de l'invention est l'installation décrite dans le brevet japonais n° 54-18989 du 4 octobre 1977 et qui est représentée aux figures 1 et 2.

Cette installation est destinée au dépôt de revêtement sur des barres, mais elle ne peut s'appliquer à la réalisation de revêtements sur des aubes de turbines à gaz.

On peut noter les différents inconvénients ci-après :
a) les pièces à revêtir sont logées à partir d'une ouverture de la chambre de travail ce qui engendre une action négative de l'adhésion de la couche pulvérisée à la base ;
b) la construction du support pour les pièces à revêtir est complexe ;
c) la protection des organes d'entraînement des pièces à revêtir est délicate. L'accroissement du condensat sur ces organes engendre un freinage et éventuellement un gauchissement qui exclut un entraînement régulier des pièces à revêtir et donc la formation d'un revêtement uniforme.
d) Les pièces à revêtir étant disposées tout autour d'un support, plus celui-ci porte des pièces, plus est importante la surface du support de sorte que la vapeur d'alliage n'atteint pas les pièces à revêtir.

La présente invention remédie à ces divers inconvénients.

L'invention va maintenant être décrite avec plus de détails en se référant à un mode de réalisation particulier donné à titre d'exemple seulement et représenté aux dessins annexés.

Figure 3 montre schématiquement en coupe l'installation, selon l'invention.

Figure 4 montre en coupe à plus grande échelle la chambre technologique.

Figure 5 est une vue en coupe suivant la ligne 5-5 de la figure 4.

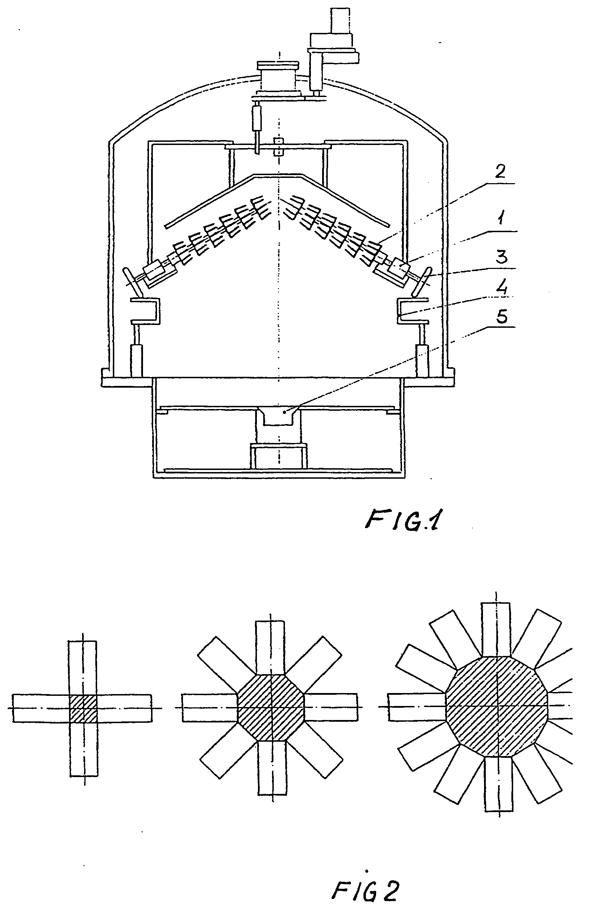

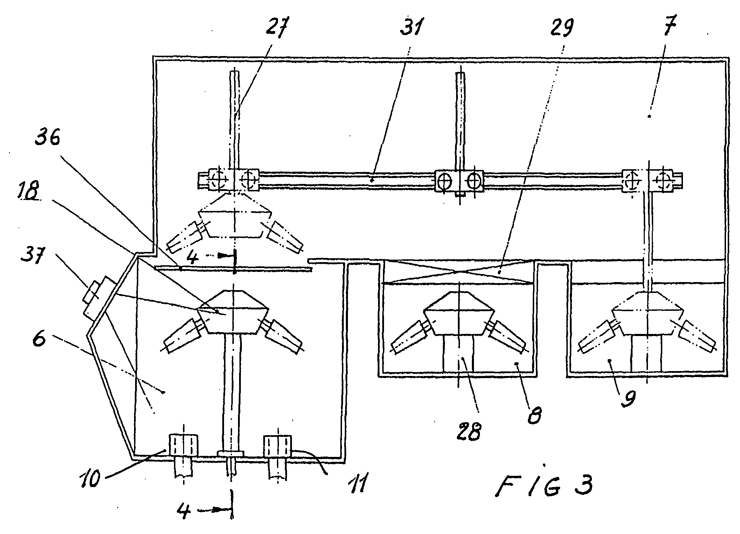

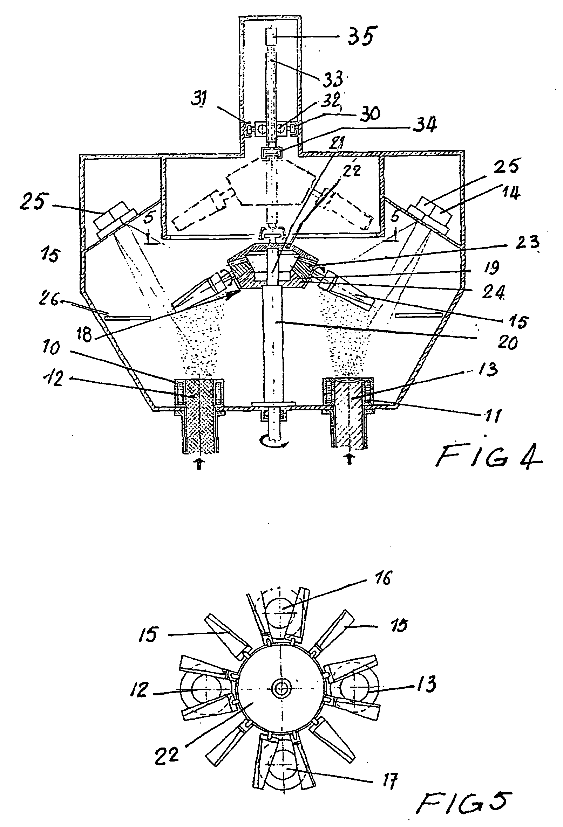

L'installation de la figure 3 comprend quatre chambres sous vide raccordées entre elles, une chambre principale technologique 6, une chambre de passage 7 et deux chambres 8 et 9.

La chambre technologique comprend des creusets 10 et 11 refroidis par une circulation d'eau et dans lesquels sont agités des matériaux coulés 12 et 13 devant servir à la réalisation du revêtement protecteur. Le nombre de creusets peut varier en fonction de la composition chimique du matériau.

Dans la chambre 6 s'étend un ensemble de support comprenant un axe 21 sur lequel est calé un pignon conique 19 et entraîné en rotation par des moyens non représentés. L'axe 21 est guidé dans un manchon 20.

Le pignon conique 19 coopère avec une série de pignons coniques 23 maintenus par un pignon 22 tournant fou sur l'axe 21. Chaque pignon conique 23 est pourvu de moyens pour la fixation d'une pièce à revêtir 15 avec une bague 24 de protection des pignons 23.

Des canons 14 à faisceaux d'électrons débouchent dans la chambre 6 et sont dirigés vers les creusets 10 et 11. Les canons sont destinés à vaporiser les matériaux des creusets 10 et 11;

Pour le chauffage préliminaire des pièces 15 à revêtir, on utilise des canons électroniques 25. Au cours de ce processus, les pièces à revêtir sont protégées par des écrans mobiles 26 afin d'éviter le dépôt d'un condensat sur lesdites pièces insuffisamment chauffées.

Lorsque la bonne température est atteinte, les écrans 26 s'ouvrent selon un programme donné, à l'aide d'un système automatisé.

Comme montré à la figure 5, l'installation peut comprendre une série de creusets 16, 17 ; le pourcentage de matériau vaporisé et destiné à revêtir la pièce est plus important au voisinage de l'axe vertical des creusets et diminue lorsque ladite pièce s'éloigne dudit axe.

On peut prévoir des écrans verticaux s'étendant jusqu'au voisinage des pièces à revêtir afin de réaliser des revêtements ce qui facilite la réalisation de revêtements microcouches, sans interface de transition et de concentration entre les couches.

Dans le mode de réalisation représenté à la figure 3, lorsque les pièces sont convenablement revêtues, un manipulateur 27 accroche le support 18 et le soulève pour l'amener dans la chambre de passage 7, puis le déplace pour le loger dans la chambre 8 sur un organe d'appui 28 de manière que les pièces revêtues soient refroidies. Durant le refroidissement, on place dans la chambre 7 un second support 18 garni de nouvelles pièces à revêtir. La chambre 8 est fermée par une porte 29 et le refroidissement est accéléré par envoi d'air dans la chambre 8.

Dans la chambre 9 ainsi garnie, on fait le vide, puis le manipulateur 27 prélève le support de la chambre 9 et l'amène dans la chambre 6 pour un nouveau processus de revêtement et ainsi de suite.

Le manipulateur 27 comporte un chariot 30 mobile sur des rails 31 et logé dans la chambre 7. Le chariot est pourvu de moyens 32 coopérant avec une tige 33 pourvue d'une pince 34 destinée à coopérer avec l'organe d'accrochage 39 du support 18. La pince 34 peut être commandée par un électro-aimant 35. Le chariot 30 comporte des moyens électromécaniques pour commander le coulissement vertical de la tige 33 ainsi que son déplacement sur les rails 31.

Il est prévu un écran mobile 36 qui peut être effacé pour la mise en place du support 18 dans la chambre 6 et replacé ensuite afin de séparer la chambre 6 de la chambre 7 et ainsi l'arrivée du condensat dans la chambre 7 lors du processus de revêtement.

L'installation comporte un système de vérification stroboscopique 37 du processus de revêtement disposé sur une porte de la chambre 6.

L'installation, selon l'invention, est plus simple que les installations connues et permet de déposer des revêtements de tous types.

Les exemples ci-après montrent les possibilités offertes par l'installation :
1) dépôt d'un revêtement monocouche de type MeCrAlY sur des aubes des turbines. Dans les creusets 10, 11 de la chambre 6, on place des matériaux coulés de l'alliage NoCrAlY. Dans les chambres 8, 9, on charge les supports avec les pièces à revêtir. L'installation est étanchée et traitée au vide. Après que le degré nécessaire de vide ait été atteint, le support 18 avec les pièces est placé dans la chambre de travail 6, les écrans 26 sont fermés à l'aide des canons électroniques 25, on chauffe les produits 15 jusqu'à la température donnée, tandis qu'avec les canons à faisceaux d'électrons 14, on effectue le passage au mode déterminé de la vaporisation des matériaux coulés 12, 13. Après chauffage des pièces et vaporisation des matériaux, les écrans 26 sont ouverts et on effectue le dépôt du revêtement sur les produits.
2) dépôt d'un revêtement monocouche de type MeCrAlYHfSi sur des aubes de turbines à gaz.
   Dans les creusets 10, 11 de la chambre 6, on place les produits coulés de l'alliage CoCrAlY et dans les creusets 16, 17 respectivement les produits coulés de l'hafnium et du silicium. Dans les chambres 8, 9, on charge les supports 18 avec les pièces à revêtir. L'installation est étanchée et on fait le vide. Après que le degré nécessaire de vide ait été atteint, le support 18 avec les pièces est placé dans la chambre 6. Les écrans 26 étant fermés à l'aide des canons à faisceaux d'électrons 25, on chauffe les pièces 15 jusqu'à la température donnée, et il est effectué en même temps le passage au mode de vaporisation des matériaux coulés placés dans les creusets 11, 12, 13, 14. Les écrans 26 sont ensuite ouverts et il est effectué le dépôt du revêtement sur les pièces.
3) dépôt d'un revêtement à deux couches de type MeCrAlY/ZrO₂-Y₂O₃ sur des aubes de turbines à gaz.
   Dans les creusets 11, 12 de la chambre de travail 6, on place des matériaux coulés de l'alliage CoCrAlY ou MeCrAlY, et dans les creusets 16, 17 respectivement les barreaux de céramique ZrO₂ - de 6 à 8% massique de Y2O₃. Dans les chambres 8, 9 respectivement, on place les supports 18 garnis de pièces à revêtir 15. L'installation est étanchée et le vide est fait, le support 18 avec les pièces 15 est placé dans la chambre 6. Les écrans 26 étant fermés à l'aide des canons à faisceaux d'électrons 25, on chauffe les pièces 15 jusqu'à une température déterminée et on effectue le passage au mode de vaporisation des matériaux coulés et des barreaux placés dans les creusets 11, 12, 16 et 17. Après le chauffage des produits et la vaporisation des matériaux, on déconnecte les canons dirigés vers les creusets contenant la céramique et les écrans 26 sont ouverts. On effectue le dépôt de la couche interne métallique MeCrAlY. Après l'achèvement du processus du dépôt de la couche interne métallique résistant aux hautes températures, les canons vaporisant l'alliage MeCrAlY sont déconnectés, et les canons vaporisant la céramique sont connectés et ainsi la formation du revêtement extérieur céramique ZrO₂-Y2O₃ est effectuée. Le dépôt du revêtement de deux couches MeCrAlY/ZrO₂-Y2O₃ est effectué au cours d'un seul cycle technologique. Il est facile de créer une interface déterminée de faible transition de concentration entre les composants métallique et céramique du revêtement à deux couches.
4) dépôt d'un revêtement siliciuré de type CrSi₂₋MoSi₂ sur des aubes de turbines à gaz.
   Dans les creusets 11, 12, 16, 17, on place successivement les produits coulés du chrome, du silicium, du molybdène. Après le traitement sous vide et le passage aux modes de vaporisation de chauffage des pièces à revêtir, les écrans 26 sont ouverts et on effectue le dépôt du revêtement siliciuré ayant un composé chimique complexe. En faisant varier les vitesses de vaporisation du Cr, Mo et Si, il est facile de régler la composition chimique des revêtements.
5) dépôt d'un revêtement microcouche de CrSi₂-MOSi₂ sur des aubes de turbines à gaz.

Le processus du dépôt du revêtement microcouche est différent de celui décrit dans l'exemple 4, car il est exécuté par enclenchement alterné avec les intervalles déterminés des canons à faisceaux d'électrons qui font vaporiser les produits coulés du Cr, Si et Mo respectivement. On peut former des revêtements avec l'alternance des couches de siliciure de chrome/siliciure de molybdène ayant des épaisseurs et compositions chimiques déterminés, en fonction de l'intervalle de temps et de la vitesse de la vaporisation des composants.

Ces exemples ne sont pas limitatifs et on pourrait en citer d'autres.

Bien entendu, l'invention n'est pas limitée au mode de réalisation qui vient d'être décrit et représenté. On pourra y apporter de nombreuses modifications de détail sans sortir pour cela du cadre de l'invention définie par les revendications ci-jointes.

## Revendications

1. Installation de revêtements de pièces par faisceaux d'électrons de type comprenant une chambre (6) avec des moyens pour la maintenir sous vide, des creusets (10, 11) destinés à recevoir des matériaux à vaporiser, des canons à électrons (25, 14) destinés à engendrer la vaporisation des matériaux, un support (18) pour les pièces à revêtir (15) **caractérisée en ce que** le support (18) est monté sur un axe vertical (22) relié à des moyens pour son entraînement en rotation et comporte, calé, un pignon conique (24) entraînant une série de pignons coniques (23) reliés à des moyens pour la fixation des pièces à revêtir (15) de manière que ces dernières soient dirigées avec leur extrémité libre tournée vers les creusets.

2. Installation de revêtements de pièces par faisceaux d'électrons, selon la revendication 1, **caractérisée en ce qu'**elle comporte des volets (26) pour isoler les pièces à revêtir (15) durant un préchauffage desdites pièces à revêtir.

3. Installation de revêtements de pièces par faisceaux d'électrons, selon la revendication 1, **caractérisée en ce que** le support (18) des pièces à revêtir est monté de manière amovible sur l'axe vertical (22).

4. Installation de revêtements de pièces par faisceaux d'électrons, selon les revendications 1 et 3, **caractérisée en ce qu'**elle comporte une première chambre (9) destinée à recevoir un support (18) garni de pièces à revêtir (15), des moyens pour faire le vide (27) dans ladite première chambre, une chambre de passage (7) maintenue sous vide et comportant un manipulateur (27) pour prélever le support logé dans la première chambre et l'amener dans la chambre (6) dans laquelle les pièces à revêtir doivent être revêtues et une troisième chambre (8) de refroidissement destinée à recevoir le support avec les pièces (15) revêtues.

## Claims

1. Installation for coating work pieces using electron beams of the type comprising a chamber (6) with means for holding it under vacuum, crucibles (10, 11) designed to receive the materials to be vaporised, electron guns (25, 14) designed to cause the vaporisation of the materials, and a support (18) for the work pieces to be coated (15), **characterised in that** the support (18) is mounted on a vertical axle (22) connected to means for driving it in rotation and comprises, fixed, a conical pinion (24) which drives a series of conical pinions (23) connected to means for securing the work pieces to be coated (15) so that the latter are oriented with their free ends turned towards the crucibles.

2. Installation for coating work pieces using electron beams according to claim 1, **characterised in that** it comprises shutters (26) for isolating the work pieces to be coated (15) during a preheating phase of said work pieces to be coated.

3. Installation for coating work pieces using electron beams according to claim 1, **characterised in that** the support (18) for the work pieces to be coated is mounted in a moveable manner on the vertical axle (22).

4. Installation for coating work pieces using electron beams according to claims **1 and 3, characterised in that it comprises a first chamber (9) designed to** receive a support (18) that is provided with work pieces to be coated (15), means for producing the vacuum (27) in said first chamber, a transit chamber (7) that is held under vacuum and comprises a manipulator (27) for taking the support housed in the first chamber and conveying it into the chamber (6) in which the work pieces to be coated are to be coated, and a third cooling chamber (8) designed to receive the support with the coated work pieces. (15).

## Patentansprüche

1. Anlage zum Elektronenstrahlbeschichten von Werkstücken, die von derjenigen Art ist, die eine Kammer (6) mit Mitteln, um sie unter Vakuum zu halten, Tiegel (10, 11), die dazu vorgesehen sind, zu verdampfende Materialien aufzunehmen, Elektronenstrahlkanonen (25, 14), die dazu vorgesehen sind, die Verdampfung der Materialien zu bewirken, und einen Träger (18) für die zu beschichtenden Werkstücke (15) umfasst, **dadurch gekennzeichnet, dass** der Träger (18) auf einer vertikalen Achse (22) angebracht ist, die mit Mitteln, um sie in Drehung zu versetzen, verbunden ist und ein auf ihr befestigtes Kegelrad (24) umfasst, das eine Reihe von Kegelrädern (23) antreibt, die mit Mitteln verbunden sind, um zu beschichtende Werkstücke (15) derart zu fixieren, dass Letztere mit ihrem freien Ende auf die Tiegel gerichtet sind.

2. Anlage zum Elektronenstrahlbeschichten von Werkstücken nach Anspruch 1, **dadurch gekennzeichnet, dass** sie Klappen (26) umfasst, um die zu beschichtenden Werkstücke (15) während einer Vorheizung der genannten, zu beschichtenden Werkstücke zu isolieren.

3. Anlage zum Elektronenstrahlbeschichten von Werkstücken nach Anspruch 1, **dadurch gekennzeichnet, dass** der Träger (18) der zu beschichtenden Werkstücke auf der vertikalen Achse (22) unbeweglich angeordnet ist.

4. Anlage zum Elektronenstrahlbeschichten von Werkstücken nach den Ansprüchen 1 und 3, **dadurch gekennzeichnet, dass** sie eine erste Kammer (9), die zur Aufnahme eines Trägers (18) vorgesehen ist, der mit zu beschichtenden Werkstücken (15) versehen ist, Mittel (27), um in der genannten ersten Kammer Vakuum zu erzeugen, eine Durchgangskammer (7), die unter Vakuum gehalten ist und einen Manipulator (27) aufweist, um den in der ersten Kammer befindlichen Träger anzuheben und ihn in die Kammer (6) zu bewegen, in der die zu beschichtenden Werkstücke beschichtet werden müssen, sowie eine dritte Kühlkammer (8) umfasst, die dazu vorgesehen ist, den Träger mit beschichteten Werkstücken (15) aufzunehmen.
